(19) Europäisches Patentamt

European Patent Office

Office européen des brevets

(11) Veröffentlichungsnummer: **0 317 934 B1**

(12) **EUROPÄISCHE PATENTSCHRIFT**

(45) Veröffentlichungstag der Patentschrift: **30.09.92**

(21) Anmeldenummer: **88119351.0**

(22) Anmeldetag: **21.11.88**

(51) Int. Cl.⁵: **H01L 27/10**, H01L 21/82

(54) **Dreidimensionale 1-Transistorzellenanordnung für dynamische Halbleiterspeicher mit Grabenkondensator und Verfahren zu ihrer Herstellung.**

(30) Priorität: **26.11.87 DE 3740171**

(43) Veröffentlichungstag der Anmeldung:
**31.05.89 Patentblatt 89/22**

(45) Bekanntmachung des Hinweises auf die Patenterteilung:
**30.09.92 Patentblatt 92/40**

(84) Benannte Vertragsstaaten:
**AT DE FR GB IT NL**

(56) Entgegenhaltungen:
**EP-A- 0 168 528**
**EP-A- 0 220 410**

**PATENT ABSTRACTS OF JAPAN, Band 9, Nr. 298, (E-361)[2021], 26. November 1985, Seite 37 E 361; & JP-A-60 136 366 (HITACHI SEISA-KUSHO K.K.) 19-07-1985**

(73) Patentinhaber: **SIEMENS AKTIENGESELL-SCHAFT**
**Wittelsbacherplatz 2**
**W-8000 München 2(DE)**

(72) Erfinder: **Kircher, Roland, Dr.**
**Guldeinstrasse 40a**
**W-8000 München 2(DE)**
Erfinder: **Götzlich, Josef, Dr.**
**Siegfriedstrasse 17**
**W-8000 München 40(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine dreidimensionale 1-Transistorzellenanordnung für dynamische Halbleiterspeicher, bei der der Kondensator für die zu speichernden Ladungen als Grabenkondensator (trench capacitor) im Substrat ausgebildet ist, wobei die erste Elektrode des Grabenkondensators durch das Substrat und die zweite, die Ladungen speichernde Elektrode des Grabenkondensators durch im Graben aufgefülltes dotiertes polykristallines Silizium gebildet ist, und bei der der Kondensator getrennt durch eine Isolationsschicht, unterhalb des an der Oberfläche des Substrates liegenden Feldeffekttransistors (Auswahltransistor) mit isolierter Gateelektrode (Transfer-Elektrode/Wortleitung) und mit in der auf der Isolationsschicht aufgebrachten rekristallisierten Siliziumschicht erzeugten Source/Drainzonen angeordnet ist und mit dessen Source/Drainzonen über einen elektrisch leitenden Kontakt verbunden ist.

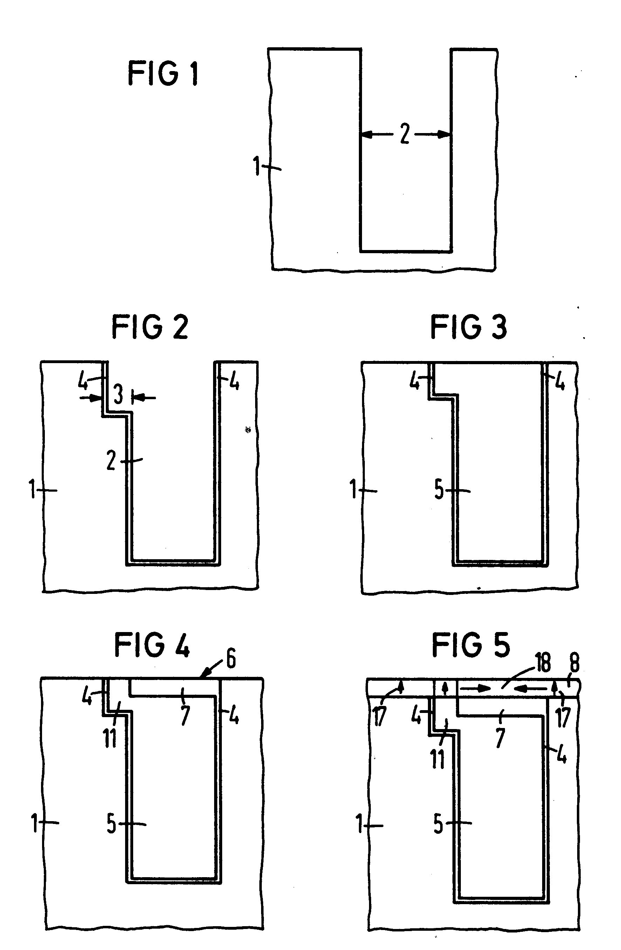

Eine solche Anordnung ist beispielsweise aus der europäischen Patentanmeldung en 0 220 410 oder 0 167 764 oder dem Bericht von M. Ohkura et. al. "A Three-Dimensional DRAM Cell Of Stakked Switching-Transistor in SOI" in IEDM Digest of Technical Papers, 1985, pp. 718 bis 721, insbesondere Figur 1, zu entnehmen. Dabei bedeutet die SOI-Technik die sogenannte Silicon on Insulator-Technik.

Weitere 1-Transistorzellen-Grabenkondensator-Anordnungen sind auch aus den europäischen Patentanmeldungen 0 234 384 und 0 108 390, allerdings hier ohne SOI-Technik, zu entnehmen.

Allen diesen Anordnungen ist gemeinsam, daß zur Erhöhung der Packungsdichte bei dynamischen Speichern (DRAMs) aus Gründen der kleineren, zur Verfügung stehenden Zellflächen und aufgrund der für die Störsicherheit erforderlichen Kapazitätsgrößen von 30 bis 50 fF der Kondensator als Grabenzelle ausgeführt ist.

Durch Nutzung der dritten Dimension in der Grabenzelle ist die Möglichkeit gegeben, bei minimalem Platzbedarf eine Zellkapazität von 40 fF zu realisieren.

Durch die Einführung der Silicon on Insulator-Technik, wie in dem Bericht von Ohkura beschrieben, wird erreicht, daß die Soft-Error-Empfindlichkeit vermindert wird und ein kleiner Flächenbedarf in der Größenordnung von 5 $\mu m^2$ realisierbar wird.

Aufgabe der Erfindung ist es, eine dreidimensionale 1-Transistorzellenanordnung der eingangs genannten Art für höchstintegrierte dynamische Speicherschaltungen anzugeben, bei denen ein minimaler Flächenbedarf pro Zelle von kleiner 3 $\mu m^2$ möglich ist und bei denen Punch Through und Soft-Error-Empfindlichkeit vermieden wird.

Eine weitere Aufgabe der Erfindung ist es, diese Zellen mit diesem Integrationsgrad in integrierten Schaltungen mit möglichst einfachen, technisch beherrschbaren Verfahrensschritten herzustellen.

Zur Lösung der erfindungsgemäßen Aufgabe wird eine dreidimensionale 1-Transistorzellenanordnung der eingangs genannten Art vorgeschlagen, bei die weiter

a) der elektrisch leitende Kontakt durch eine im oberen Teil des Grabens in das Substrat eingebrachte asymmetrische Erweiterung der Grabenöffnung, die mit gleichdotierten polykristallinen Silizium wie im Graben gefüllt ist, gebildet ist und der kontakt (11) ein Teilgebiet der die Ladung speichernden zweiten Elektrode des Kondensators darstellt,

b) die den Transistor vom Kondensator trennende Isolationsschicht neben der asymmetrischen Erweiterung der Grabenöffnung im Graben mit der gleichen Geometrie wie der ursprüngliche Grabenquerschnitt angeordnet ist und

c) die Gateelektrode des Transistors über der Isolationsschicht und auch über der darüber befindlichen rekristallisierten Siliziumschicht so angeordnet ist, daß die in der rekristallisierten Siliziumschicht erzeugte Sourcezone den elektrisch leitenden Kontakt in der asymmetrischen Erweiterung der Grabenöffnung überlappt.

Weitere Ausgestaltungen der Erfindung, insbesondere Verfahren zu ihrer Realisierung, ergeben sich aus den Unteransprüchen.

Bei dem erfindungsgemäßen Zellkonzept wird ein sehr geringer Flächenbedarf von weniger als 3 $\mu m^2$ pro Zelle erhalten, wodurch eine sehr hohe Integrationsdichte erzielbar ist. Negative Begleiterscheinungen wie Punch Through müssen nicht befürchtet werden. Außerdem ist die Soft-Error-Empfindlichkeit sehr gering. Die Technologie zu ihrer Herstellung besteht aus einer Kombination von Trench-Prozeß, SOI-Prozeßschritten und einem Standard-MOS-Prozeß für den Schalttransistor. Obwohl ein Teilprozeß aus SOI-Prozeßschritten besteht, werden die bekannten Nachteile, die mit floatenden Substraten verknüpft sind, vermieden. Die Prozeßschritte können im Gegenteil sogar dazu benutzt werden, die Transistoreigenschaften zu optimieren.

Im folgenden wird anhand von Ausführungsbeispielen und der Figuren 1 bis 10 die Erfindung noch näher beschrieben. Dabei zeigen

die Figuren 1 bis 9

im Schnittbild die erfindungswesentlichen Verfahrensschritte bis zur Fertigstellung der Zelle und

die Figur 10

das Layout der Figur 9.

Gleiche Teile sind in allen Figuren mit gleichen Bezugszeichen bezeichnet.

Figur 1:

Ausgehend von einem hochdotierten Siliziumsubstrat 1 mit p-Dotierung ($N_A$ größer $10^{18}$ cm$^{-3}$) wird ein ca. 6 $\mu$m tiefer Trench-Graben 2 mit einem quadratischen Querschnitt von 1 $\mu$m mal 1 $\mu$m geätzt.

Figur 2:

Anschließend wird in die eine Seitenwand des Trenches 2 asymmetrisch geätzt, so daß eine ca. 1 $\mu$m tiefe und 0,4 $\mu$m weite Vergrößerung 3 der Trenchöffnung 2 entsteht. Erst danach werden die Seitenwände des Trenches 2 und der asymmetrischen Erweiterung 3 mit einem Dreifachdielektrikum 4, bestehend aus Siliziumoxid-Siliziumnitrid-Siliziumoxid mit der effektiven Schichtdicke 15 nm versehen.

Figur 3:

Der Trench 2, 3, 4 wird nun mit hochdotiertem (Arsen) polykristallinem Silizium 5 gefüllt. Dieses polykristalline Silizium 5 dient als Elektrode zur Ladungsspeicherung. Die andere Elektrode wird durch das hochdotierte Siliziumsubstrat 1 gebildet.

Figur 4:

Nun wird das den Trench 2 ausfüllende polykristalline Silizium 5 um ca. 0,5 $\mu$m zurückgeätzt, um eine Vertiefung (siehe Pfeil 6) mit dem Querschnitt des ursprünglichen Trenchgrabens 2 zu schaffen. Die einseitige (asymmetrisch) Erweiterung 3 des Grabens 2 bleibt durch Maskierung von diesem Ätzschritt unbeeinflußt (in der Figur nicht dargestellt), da sie den Kontakt zum später zu erzeugenden Auswahltransistor darstellt. In das so hergestellte Loch (6) wird durch Abscheidung aus der Gasphase (CVD) ein Siliziumoxid 7 (SiO$_2$) eingebracht, welches zur Isolation zwischen Trenchkondensator (1, 4, 5) und dem späteren Auswahltransistor dient.

Figur 5:

Nach Planarisierung der Oberfläche wird ein mit Bor niedrig dotiertes polykristallines Silizium bzw. amorphes Silizium 8 auf der Oberfläche des Substrats abgeschieden. Für die anschließend Rekristallisation dieser abgeschiedenen Siliziumschicht 8 werden folgende Alternativen vorgeschlagen:

1. Die Schicht 8 besteht aus amorphem Silizium, welches durch eine Silizium-Implantation (in der Figur nicht dargestellt) zusätzlich amorphisiert werden kann. Bei der anschließenden Temperung bei 550 bis 600°C rekristallisiert diese Schicht 8 sowohl vertikal (siehe Pfeile 17) als auch lateral (siehe Pfeile 18) über dem SiO$_2$-Gebiet 7 über dem Trenchkondensator. Diese Variante ist in Figur 5 dargestellt.

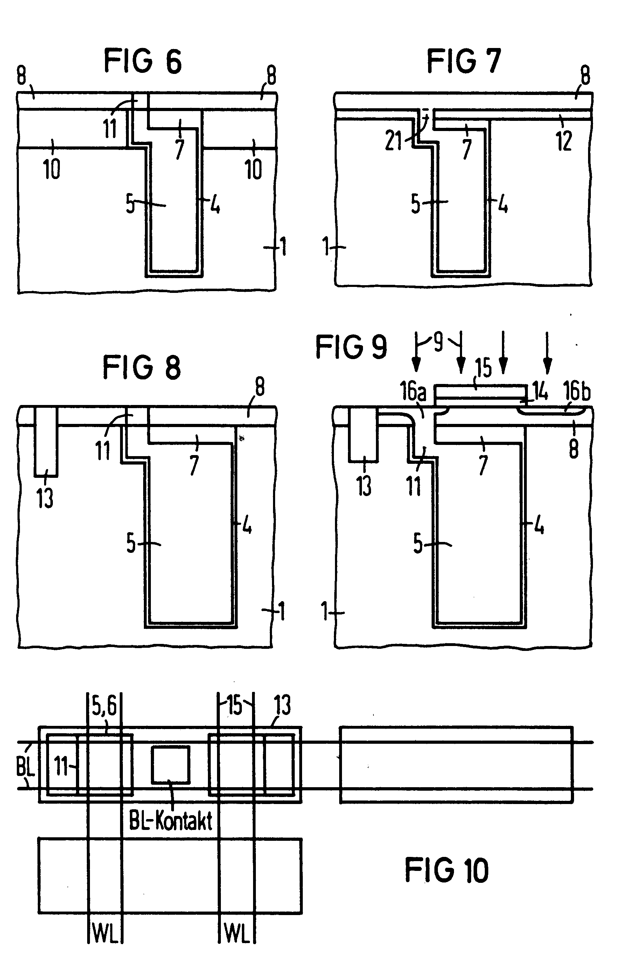

2. Es werden p$^+$-Siliziumsubstrate 1 mit einer p$^-$-Epitaxieschicht 10 verwendet. Nach der Herstellung des Trenchkondensators 1, 4, 5 wird eine amorphe Siliziumschicht 8 abgeschieden, die durch vertikale Oberflächenepitaxie bzw. laterale Oberflächenepitaxie rekristallisiert wird. Bei nicht genügender Kristallqualität kann diese Schicht 8 zusätzlich mit einem Laserstrahl rekristallisiert werden. Der n$^+$-Kontakt 11 zum Trench 1, 2, 4, 5 wird anschließend durch einen Maskenprozeß und Temperung/Diffusion hergestellt. Diese Anordnung ist in Figur 6 dargestellt.

3. Nach der Herstellung des Trenchkondensators 1, 2, 4, 5 wird eine CVD- oder thermische Oxidschicht 12 abgeschieden bzw. erzeugt, die über dem n$^+$-Anschluß (11) abgeätzt wird. Anschließend wird dieses Gebiet durch lokale, selektive Epitaxie (siehe Pfeil 21) aufgefüllt. Danach erfolgt eine ganzflächige Polysiliziumabscheidung 8. Diese polykristalline Siliziumschicht 8 wird anschließend durch Laserbestrahlung rekristallisiert. Diese Variante zeigt Figur 7.

Es kann aber auch so verfahren werden, daß nach der Herstellung des Trenchkondensators wie beim dritten Ausführungsbeispiel beschrieben, eine ganzflächige LPCVD-Oxidschicht abgeschieden wird und über dem n$^+$-Kontakt abgeätzt wird. Danach erfolgt eine Abscheidung von amorphem Silizium mit anschließender planarisierender Rückätzung. Nach einer Silizium-Ionenimplantation zur weiteren Amorphisierung wird bei 550 bis 600°C die laterale Festphasenepitaxie, ausgehend vom n$^+$-Kontakt (11) zum Substrat (1) durchgeführt.

Figur 8:

Die Dicke der abgeschiedenen Siliziumschicht 8 sollte ca. 0,4 $\mu$m betragen. Bevor nun in diese Schicht 8 nach deren Rekristallisation ausgehend von Figur 5 der Auswahltransistor über dem Trench 1, 2, 4, 5 eingebracht wird, wird zur Vermeidung von Punch Through und Übersprechen zwischen benachbarten Zellen die sogenannte Box-Isolation ausgeführt. Diese besteht darin, daß in das Substrat 1 bzw. die rekristallisierte Schicht 8 Gräben 13 mit einer Breite von 0,5 $\mu$m und einer Tiefe von 0,7 $\mu$m eingeätzt werden, die dann mit Siliziumoxid (13) aufgefüllt werden.

Figur 9:

Nun wird in der rekristallisierten Bor-dotierten Siliziumschicht 8 der Auswahltransistor erzeugt. Dazu wird zunächst das Gateoxid 14 aufgewachsen und darüber die aus dotierten polykristallinem Silizium oder Metallsilizid bestehende Gateelektrode 15 abgeschieden. Durch Arsen-Ionenimplantation (siehe Pfeile 9) werden nun unter Verwendung der Gateelektrode 15 als Implantationsmaske die Source/Drainzonen 16a, 16b erzeugt. Dabei wird darauf geachtet, daß das eine Arsen-Gebiet 16a sich möglichst gut mit dem n$^+$-Kontakt 11 des Kondensators überlappt.

Der so mit Standard-Technologie hergestellte Transistor hat eine effektive Kanallänge von ca. 0,8 $\mu$m und eine Weite von 1 $\mu$m. Eine Abschätzung für die Kapazität des Trenchkondensators ergibt: C ungefähr 55 fF, wobei eine minimale effektive Tiefe von 5 $\mu$m bei einem Querschnitt von 1 $\mu$m$^2$ zugrundegelegt wurde. Da die Ladung innerhalb des Trenches (5) gespeichert wird, und bei Verwendung einer Box-Isolation (13) zwischen benachbarten Trenches so gut wie keine Soft-Error-Empfindlichkeit zu erwarten ist, dürfte die oben angegebene Kapazität reichlich dimensioniert sein.

Das Kanalgebiet des Transistors hat seitlich Kontakt zum hochdotierten Substrat (1), so daß selbst bei großer vertikaler Ausdehnung der Source/Drain-Raumladungszone das Kanalgebiet auf Substratpotential liegt. Dadurch werden die bekannten Nachteile von floatenden Gebieten (wie im Bericht von Ohkura beschrieben) auf die Transistoreigenschaften vermieden.

Ein weiterer Vorteil ist, daß die Dotierung der abgeschiedenen Siliziumschicht 8 zur Optimierung wichtiger Transistoreigenschaften, wie zum Beispiel der Einsatzspannung, herangezogen werden kann.
Figur 10:
Das Layout der Zellanordnung läßt erkennen, daß eine sehr dichte Packung durch die vorgeschlagene 3-dimensionale Bauweise ermöglicht wird. Je zwei benachbarte Zellen werden zu einem Block zusammengefaßt; sie besitzen einen gemeinsamen Bitleitungskontakt (BL-Kontakt) und werden von benachbarten Zellblöcken durch die BOX-Isolation (13) getrennt. Mit WL sind die Wortleitungen bezeichnet. Ansonsten gelten die gleichen Bezugszeichen wie in Figur 9.

**Patentansprüche**

1. Dreidimensionale 1-Transistorzellenanordnung für dynamische Halbleiterspeicher, bei die weiter bei der der Kondensator für die zu speichernden Ladungen als Grabenkondensator (1, 4, 5) (trench capacitor) im Substrat (1) ausgebildet ist, wobei die erste Elektrode des Grabenkondensators durch das Substrat (1) und die zweite, die Ladungen speichernde Elektrode des Grabenkondensators durch im Graben aufgefülltes dotiertes polykristallines Silizium (9) gebildet ist, bei der weiter bei der der Kondensator, getrennt durch eine Isolationsschicht (7) unterhalb des an der Oberfläche des Substrates (1) liegenden Feldeffekttransistors (Auswahltransistor) mit isolierter Gateelektrode (14, 15) (Transfer-Elektrode/Wortleitung) und mit in der auf der Isolationsschicht (7) aufgebrachten, rekristallisierten Siliziumschicht (8) erzeugten Source/Drainzonen (16a, 16b) angeordnet ist und mit dessen Source/Drainzonen (16a) über einen elektrisch leitenden Kontakt (11) verbunden ist, der elektrisch leitende Kontakt (11) durch eine im oberen Teil des Grabens (2) in das Substrat (1) eingebrachte asymmetrische Erweiterung (3) der Grabenöffnung, die mit gleich dotierten polykristallinem Silizium (5) wie im Graben gefüllt ist, gebildet ist und der Kontakt (11) ein Teilgebiet der die Ladung speichernden zweiten Elektrode (5) des Kondensators darstellt, die den Transistor vom Kondensator trennende Isolationsschicht (7) neben der asymmetrischen Erweiterung (3) der Grabenöffnung im Graben mit der gleichen Geometrie wie der ursprüngliche Grabenquerschnitt angeordnet ist, und bei der ferner bei der die Gateelektrode (15) des Transistors über der Isolationsschicht (7) und auch über der darüber befindlichen rekristallisierten Siliziumschicht (8) so angeordnet ist, daß die in der rekristallisierten Siliziumschicht (8) erzeugte Sourcezone (16a) den elektrisch leitenden Kontakt (11) in der asymmetrischen Erweiterung (3) der Grabenöffnung überlappt.

2. Dreidimensionale 1-Transistorzellenanordnung nach Anspruch 1, **dadurch gekennzeichnet,** daß die Tiefe der asymmetrischen Erweiterung (3) der Grabenöffnung auf maximal 20 % der Grabentiefe und die Erweiterung auf maximal 50 % des Grabenquerschnittes eingestellt ist.

3. Dreidimensionale 1-Transistorzellenanordnung nach Anspruch 1 oder 2, **dadurch gekennzeichnet,** daß der Querschnitt des Grabens (2) im Bereich von 1 $\mu$m . 1 $\mu$m bei einer Tiefe von 6 $\mu$m eingestellt ist.

4. Dreidimensionale 1-Transistorzellenanordnung nach einem der Ansprüche 1 bis 3, **dadurch gekennzeichnet,** daß die asymmetrische Erweiterung (3) der Grabenöffnung im Substrat (1) auf ca. 0,4 $\mu$m und ca. 1 $\mu$m Tiefe bei einer Grabentiefe (2) im Bereich von 4 bis 6 $\mu$m eingestellt ist.

5. Dreidimensionale 1-Transistorzellenanordnung nach einem der Ansprüche 1 bis 4, **dadurch gekennzeichnet,** daß die Dicke der Isolationsschicht (7) auf maximal 15 % der Grabentiefe eingestellt ist.

6. Dreidimensionale 1-Transistorzellenanordnung nach einem der Ansprüche 1 bis 5, **dadurch gekennzeichnet,** daß bei einer Grabentiefe (2) von ca. 6 $\mu$m und einer Tiefe der asymmetrischen Grabenerweiterung (3) von ca. 1 $\mu$m die Dicke der Isolationsschicht (7) auf ca. 0,5 $\mu$m eingestellt ist.

7. Dreidimensionale 1-Transistorzellenanordnung nach einem der Ansprüche 1 bis 6, **dadurch gekennzeichnet,** daß das Substrat (1) $p^+$-dotiert, die Grabenfüllung (5) und der asymmetrische, in der Grabenerweiterung angeordnete elektrisch leitende Kontakt (11) $n^+$-dotiert, die die Source/Drainzonen (16a, 16b) enthaltende rekristallisierte Schicht (8) $p^-$-dotiert und die darin befindlichen Source/Drainzonen (16a, 16b) $n^+$-dotiert sind.

8. Dreidimensionale 1-Transistorzellenanordnung nach einem der Ansprüche 1 bis 7, **dadurch gekennzeichnet,** daß die Isolation zwischen zwei benachbarten Grabenkondensatoren aus einem Isolationsoxid (13) besteht, welches durch einen in das Substrat (1) eingeätzten Graben und Auffüllen dieses Grabens mit $SiO_2$ erzeugt ist.

9. Dreidimensionale 1-Transistorzellenanordnung nach Anspruch 8, **dadurch gekennzeichnet,** daß die Isolationsgräben (13) eine Tiefe von ca. 0,7 $\mu$m und eine Breite von ca. 0,5 $\mu$m aufweisen.

10. Verfahren zum Herstellen einer dreidimensionalen 1-Transistorzellenanordnung nach einem der Ansprüche 1 bis 9, welches die folgenden Verfahrensschritte in der angegebenen Reihenfolge umfaßt:

a) Einbringen von Gräben (2) entsprechend der Größe des Speicherkondensators in ein $p^+$-dotiertes Halbleitersubstrat (1),

b) Einätzen einer asymmetrischen Erweiterung (3) der Grabenöffnung (2) von maximal eines halben Grabenquerschnitts in das Substrat (1) bis zu einer Tiefe von maximal 20 % der Speichergrabentiefe,

c) Aufbringen einer dielektrischen Schicht (4) für den Kondensator auf die Grabeninnenwände (2, 3),

d) Auffüllen des Grabens (einschließlich der Erweiterung) mit $n^+$-dotiertem polykristallinem Silizium (5),

e) Rückätzen des polykristallinen Silizium (5) nach vorheriger Maskierung des Bereiches der asymmetrischen Grabenerweiterung (3) zur Erzeugung einer Vertiefung (6) in der $n^+$-polykristallinen Siliziumschicht mit dem Querschnitt des ursprünglichen Grabens (2),

f) Auffüllen der Vertiefung mit $SiO_2$ (7) durch einen CVD-Prozeß (= chemical vapor deposition) und Planarisierung der Oberfläche,

g) Abscheiden einer mit Bor niedrig-dotierten polykristallinen oder amorphen Siliziumschicht (8) und anschließende Rekristallisation durch Temperung in einem Bereich von 500 bis 650°C,

h) Einbringen von Gräben (13) für die Isolation von benachbarten Grabenkondensatoren und Auffüllen dieser Gräben (13) mit $SiO_2$,

i) Herstellen des Auswahltransistors über dem Grabenkondensator (1, 4, 5, 7) durch Aufwachsen von Gateoxid (14), Erzeugen der Gateelektrode (15) und Einbringen der Source/Drainzonen (16a, 16b) durch Arsen-Ionenimplantation (9) unter Verwendung der Gateelektrode (15) als Implantationsmaske, wobei die Sourcezone (16a) das in der asymmetrischen Erweiterung (3) des Grabens liegende $n^+$-Gebiet (11), das den $n^+$-Kontakt des Kondensators bildet, überlappt, und

j) Aufbringen von Zwischenisolationsschichten, Öffnen von Kontaktlöchern und Fertigstellung der Bitleitungskontakte und der Wortleitung in bekannter Weise.

11. Verfahren nach Anspruch 10, **dadurch gekennzeichnet,** daß nach dem Abscheiden der amorphen Siliziumschicht (8) nach Verfahrensschritt g) zur zusätzlichen Amorphisierung eine Silizium-Ionenimplantation durchgeführt wird.

12. Verfahren nach Anspruch 10, **dadurch gekennzeichnet,** daß in Abänderung des Verfahrens gemäß Verfahrensschritt a) ein $p^+$-dotiertes Substrat (1) mit einer $p^-$-dotierten Silizium-Epitaxieschicht (10) verwendet wird und der $n^+$-Kontakt (11) zum Graben nach dem Verfahrensschritt g) durch maskierte Diffusion und Temperung hergestellt wird.

13. Verfahren nach Anspruch 10, **dadurch gekennzeichnet,** daß in Abänderung des Verfahrens im Anschluß an den Verfahrensschritt f) und vor dem Verfahrensschritt g) das ganzflächig abgeschiedene CVD-$SiO_2$ (7) im Bereich über dem in der asymmetrischen Erweiterung (3) befindlichen $n^+$-Gebiet (11) abgeätzt wird und dieser Bereich (11) durch lokale selektive Silizium-Epitaxieabscheidung wieder aufgefüllt wird.

14. Verfahren nach Anspruch 12 und 13, **dadurch gekennzeichnet,** daß die Rekristallisation durch Laserbestrahlung bewirkt wird.

**Claims**

1. Three-dimensional 1-transistor cell arrangement for dynamic semiconductor memories, in which the capacitor for the charges to be stored is constructed as a trench capacitor (1, 4, 5) in the substrate (1), the first electrode of the trench capacitor being formed by the substrate (1) and the second electrode of the trench capacitor, which stores the charges, being constructed by means of doped polycrystalline silicon (9), which is filled in the trench, in which the capacitor is arranged, separated by means of an insulation layer (7) underneath the field-effect transistor (selection transistor), which is located on the surface of the substrate (1), with an insulated gate electrode (14, 15) (transfer electrode/word line) and with source/drain zones (16a, 16b), which are produced in the recrystallised silicon layer (8) deposited on the insulation layer (7), and is connected to its source/drain zones (16a) via an electrically conductive contact (11), in which, furthermore, the electrically conductive contact (11) is formed by an asymmetric widening (3) of the trench opening, which is incorporated into the substrate (1) in the upper part of the trench (2), and is filled with polycrystalline silicon (5) which is doped identically to that in the trench, and the contact (11) represents a partial region of the second electrode (5) of the capacitor, which stores the charge, in which, furthermore, the insulation layer (7) which separates the transistor from the capacitor is arranged adjacent to the asymmetric widening (3) of the trench opening in the trench, with the same geometry as the original trench cross-section, and in which the gate electrode (15) of the transistor is arranged over the insulation layer (7) and also over the recrystallised silicon layer (8) which is located above it such that the source zone (16a) which is produced in the recrystallised silicon layer (8) overlaps the electrically conductive contact (11) in the asymmetric widening (3) of the trench opening.

2. Three-dimensional 1-transistor cell arrangement according to Claim 1, characterised in that the depth of the asymmetric widening (3) of the trench opening is set to a maximum of 20 % of the trench depth and the widening is set to a maximum of 50 % of the trench cross-section.

3. Three-dimensional 1-transistor cell arrangement according to Claim 1 or 2, characterised in that the cross-section of the trench (2) is set in the region of 1 $\mu$m . 1 $\mu$m with a depth of 6 $\mu$m.

4. Three-dimensional 1-transistor cell arrangement according to one of Claims 1 to 3, characterised in that asymmetric widening (3) of the trench opening in the substrate (1) is set to approximately 0.4 $\mu$m and approximately 1 $\mu$m depth with a trench depth (2) in the region of 4 to 6 $\mu$m.

5. Three-dimensional 1-transistor cell arrangement according to one of Claims 1 to 4, characterised in that the thickness of the insulation layer (7) is set to a maximum of 15 % of the trench depth.

6. Three-dimensional 1-transistor cell arrangement according to one of Claims 1 to 5, characterised in that, with a trench depth (2) of approximately 6 $\mu$m and a depth of the asymmetric trench widening (3) of approximately 1 $\mu$m, the thickness of the insulation layer (7) is set to approximately 0.5 $\mu$m.

7. Three-dimensional 1-transistor cell arrangement according to one of Claims 1 to 6, characterised in that the substrate (1) is $p^+$-doped, the trench filling (5) and the asymmetric electrically conductive contact (11), which is arranged in the trench widening, are $n^+$-doped, the recrystallised layer (8) containing the source/drain zones (16a, 16b) is $p^-$-doped and the source/drain zones (16a, 16b), located therein, are $n^+$-doped.

8. Three-dimensional 1-transistor cell arrangement according to one of Claims 1 to 7, characterised in that the insulation between two adjacent trench capacitors consists of an insulation oxide (13) which is produced by a trench which is etched into the substrate (1) and by filling this trench with $SiO_2$.

9. Three-dimensional 1-transistor cell arrangement according to Claim 8, characterised in that the insulation trenches (13) have a depth of approximately 0.7 $\mu$m and a width of approximately 0.5 $\mu$m.

10. Method for producing a three-dimensional 1-transistor cell arrangement according to one of Claims 1 to 9, which comprises the following method steps, in the specified sequence:

a) Incorporation of trenches (2) corresponding to the size of the storage capacitor in a $p^+$-doped semiconductor substrate (1),

b) Etching in of an asymmetric widening (3) of the trench opening (2) of a maximum of half a trench cross-section into the substrate (1) to a depth of a maximum of 20 % of the storage trench depth,

c) Application of a dielectric layer (4) for the capacitor onto the trench inner walls (2, 3),

d) Filling of the trench (including the widening) with $n^+$-doped polycrystalline silicon (5),

e) Etching back of the polycrystalline silicon (5) after previous masking of the region of the asymmetric trench widening (3), to produce a depression (6) in the $n^+$-polycrystalline silicon layer having the cross-section of the original trench (2),

f) Filling of the depression with $SiO_2$ (7) by means of a CVD process ( = Chemical Vapour Deposition) and flattening of the surface,

g) Deposition of a polycrystalline or amorphous silicon layer (8), which is slightly doped with boron, and subsequent recrystallisation by tempering in a region of 500 to 650°C,

h) Incorporation of trenches (13) for the insulation of adjacent trench capacitors and filling of these trenches (13) with $SiO_2$,

i) Production of the selection transistor above the trench capacitor (1, 4, 5, 7) by growing a gate oxide (14), producing the gate electrode (15) and incorporating the source/drain zones (16a, 16b) by arsenic-ion implantation (9), using the gate electrode (15) as an implantation mask, the source zone (16a) overlapping the $n^+$- region (11), which forms the $n^+$-contact of the capacitor and is located in the asymmetric widening (3) of the trench, and

j) Application of intermediate insulation layers, opening of contact holes and production of the bit line contacts and of the word line in a known manner.

11. Method according to Claim 10, characterised in that, after depositing the amorphous silicon layer (8) after method step g), a silicon-ion implantation is carried out for additional amorphicity.

12. Method according to Claim 10, characterised in that, as a variation of the method according to method step a), a $p^+$-doped substrate (1) having a p-doped silicon epitaxial layer (10) is used, and the $n^+$-contact (11) to the trench is produced according to method step g), by masked diffusion and tempering.

13. Method according to Claim 10, characterised in that, as a variation of the method in conjunction with method step f), and before the method step g), the CVD-$SiO_2$ (7), which is deposited over the complete area, in the region above the $n^+$-region (11), which is located in the asymmetric widening (3), is etched away and this region (11) is filled again by local, selective epitaxial deposition of silicon.

14. Method according to Claim 12 and 13, characterised in that the recrystallisation is effected by means of laser irradiation.

**Revendications**

1. Dispositif tridimensionnel de cellules à 1 transistor pour des mémoires dynamiques à semiconducteurs,

dans lequel le condensateur est agencé pour les charges associées en tant que condensateur en sillon (1,4,5) (trench capacitor) dans le substrat (1), la première électrode du condensateur en sillon étant formée par le substrat (1) et la seconde électrode, stockant les charges, du condensateur en sillon étant formée par du silicium polycristallin dopé (9) remplissant le sillon,

dans lequel le condensateur est disposé, en en étant séparé par une couche isolante (7), au-dessous du transistor à effet de champ (transistor de sélection) situé au-dessous de la surface du substrat (1) et comportant une électrode de grille isolée (14,15) (électrode de transfert/ligne de transmission de mots) et des zones de source/drain (16a,16b) produites dans la couche de silicium recristallisé (8), déposée sur la couche isolante (7), et dont les zones de source/drain (16a) sont réunies par un contact électriquement conducteur (11),

dans lequel en outre le contact électriquement conducteur (11) est formé au moyen d'un élargissement dissymétrique (3) de l'ouverture du sillon, qui est ménagé dans la partie supérieure du sillon (2) dans le substrat (1) et qui est rempli, comme le sillon, par du silicium polycristallin (5) dopé de la même manière, et le contact (11) représente une zone partielle de la seconde électrode (5), qui stocke la charge, du condensateur,

dans lequel en outre la couche isolante (7) séparant le transistor du condensateur est disposée, à côté de l'élargissement dissymétrique (3) de l'ouverture du sillon, dans ce sillon, avec la même géométrie que la section transversale initiale du sillon, et

dans lequel l'électrode de grille (15) du transistor est disposée au-dessus de la couche isolante (7) et également au-dessus de la couche recristallisée de silicium (8) située au-dessus de cette couche isolante, de sorte que la zone de source (16a) produite dans la couche recristallisée de silicium (8) recouvre le contact électriquement conducteur (11) dans l'élargissement dissymétrique (3) de l'ouverture du sillon.

2. Dispositif tridimensionnel de cellules à 1 transistor suivant la revendication 1, caractérisé par le fait que la profondeur de l'élargissement dissymétrique (3) de l'ouverture du sillon est réglée au maximum à 20 % de la profondeur du sillon et que l'élargissement est réglé au maximum à 50 % de la section transversale du sillon.

3. Dispositif tridimensionnel de cellules à 1 transistor suivant la revendication 1 ou 2, caractérisé par le fait que la section transversale du sillon (2) est réglée dans la plage de 1 $\mu$m.1 $\mu$m pour une profondeur de 6 $\mu$m.

4. Dispositif tridimensionnel de cellules à 1 transistor suivant la revendication 1 à 3, caractérisé par le fait que l'élargissement dissymétrique (3) de l'ouverture du sillon dans le substrat (1) est réglé à environ 0,4 $\mu$m et à une profondeur d'environ 1 $\mu$m pour une profondeur (2) du sillon dans la gamme comprise entre 4 et 6 $\mu$m.

5. Dispositif tridimensionnel de cellules à 1 transistor suivant la revendication 1 à 4, caractérisé par le fait que l'épaisseur de la couche isolante (7) est réglée au maximum à 15 % de la profondeur du sillon.

6. Dispositif tridimensionnel de cellules à 1 transistor suivant la revendication 1 à 5, caractérisé par le fait que dans le cas d'une profondeur de sillon (2) d'environ 6 $\mu$m et d'une profondeur de l'élargissement dissymétrique (3) du sillon d'environ 1 $\mu$m, l'épaisseur de la couche isolante (7) est réglée à environ 0,5 $\mu$m.

7. Dispositif tridimensionnel de cellules à 1 transistor suivant la revendication 1 à 6, caractérisé par le fait que le substrat (1) est dopé du type $p^+$, que le remplissage (5) du sillon et le contact électriquement conducteur dissymétrique (11) disposé dans l'élargissement du sillon, est dopé du type $n^+$, que la couche recristallisée (8) contenant les zones de source/drain (16a,16b) sont dopées du type $p^-$ et que les zones de source/drain (16a,16b) situées dans cette couche sont dopées du type $n^+$.

8. Dispositif tridimensionnel de cellules à 1 transistor suivant la revendication 1 à 7, caractérisé par le fait que l'isolant entre les deux condensateurs en sillon voisins est formé par un oxyde isolant (13), qui est produit par un sillon aménagé par corrosion dans le substrat (1), et remplissage de ce sillon par du $SiO_2$.

9. Dispositif tridimensionnel de cellules à 1 transistor suivant la revendication 8, caractérisé par le fait que les sillons isolants (13) possèdent une profondeur d'environ 0,7 $\mu$m et une largeur d'environ 0,5 $\mu$m.

10. Procédé pour fabriquer un dispositif tridimensionnel de cellules à I transistor suivant l'une des revendications 1 à 9, qui comprend les étapes opératoires suivantes selon la succession indiquée :

a) aménagement de sillons (2) en fonction de la taille du condensateur de mémoire dans un substrat semiconducteur (1) dopé du type $p^+$,

b) aménagement par corrosion d'un' élargissement dissymétrique (3) de l'ouverture (2) du sillon possédant une section transversale égale au maximum à la moitié de la section transversale du sillon, dans le substrat (1) jusqu'à une profondeur égale au maximum à 20 % de la profondeur du sillon de stockage,

c) dépôt d'une couche diélectrique (4) pour le condensateur sur les parois intérieures (2,3) du sillon,

d) remplissage du sillon (y compris l'élargissement) avec du silicium polycristallin (5) dopé du type $n^+$,

e) rétrocorrosion du silicium polycristallin (5) après masquage préalable de la zone de l'élargissement dissymétrique (3) du sillon pour produire un renfoncement (6) dans la couche de silicium polycristallin de type $n^+$ avec la section transversale du sillon initial (2),

f) remplissage du renfoncement avec du $SiO_2$ (7) au moyen d'un procédé CVD ( = chemical vapor deposition), c'est-à-dire dépôt chimique en phase vapeur et planarisation de la surface,

g) dépôt d'une couche (8) de silicium polycristallin ou amorphe faiblement dopé par du bore et recristallisation ultérieure par recuit dans une gamme de 500 à 650 ° C,

h) aménagement de sillons (13) pour l'isolation de condensateurs en sillon voisins et remplissage de ces sillons (13) avec du $SiO_2$,

i) fabrication du transistor de sélection au-dessus du condensateur en sillon (1,4,5,7) par croissance d'un oxyde de grille (14), production de l'électrode de grille (15) et insertion des zones de source/drain (16a,16b) au moyen d'une implantation d'ions arsenic (9) moyennant l'utilisation de l'électrode de grille (15) en tant que masque d'implantation, la zone de source (13a) chevauchant la région de type n⁺ (11), qui est située dans l'élargissement dissymétrique (3) du sillon et qui forme le contact de type n⁺ du condensateur, et

j) dépôt de couches isolantes intercalaires, ouverture de trous de contact et fabrication des contacts de la ligne de transmission de bits et de la ligne de transmission de mots, de façon connue.

11. Procédé suivant la revendication 10, caractérisé par le fait qu'après le dépôt du silicium amorphe (8) conformément à l'étape opératoire g), on exécute une implantation d'ions silicium pour obtenir le caractère amorphe supplémentaire.

12. Procédé suivant la revendication 10, caractérisé par le fait que contrairement au procédé selon l'étape opératoire a), on utilise un substrat (1) dopé de type p⁺ comportant une couche épitaxiale en silicium dopé du type p⁻ et qu'on fabrique le contact de type n⁺ (11) de liaison aux sillons conformément à l'étape opératoire g) au moyen d'une diffusion masquée d'un recuit.

13. Procédé suivant la revendication 10, caractérisé par le fait que conformément au procédé à la suite de l'étape opératoire f) et avant l'étape opératoire g), on élimine par corrosion le $SiO_2$ (7) déposé selon le procédé sur toute la surface, dans la zone située au-dessus de la région de type n⁺ (11) située dans l'élargissement dissymétrique (3), et on remplit cette région (11) au moyen d'un dépôt épitaxial sélectif local de silicium.

14. Procédé suivant les revendications 12 ou 13, caractérisé par le fait que la recristallisation est obtenue au moyen d'une irradiation par laser.

**FIG 1**

**FIG 2**

**FIG 3**

**FIG 4**

**FIG 5**

# FIG 6

# FIG 7

# FIG 8

# FIG 9

BL-Kontakt

# FIG 10